# EUROPEAN PATENT APPLICATION

(11) **EP 3 882 976 A1**
(43) Date of publication of application: **22.09.2021**
(21) Application number: 21163454.8
(22) Date of filing: 18.03.2021
(51) Int. Cl.: H01L 27/32, H01L 27/12, H01L 51/00, H01L 51/52, C23C 16/34

(54) **DISPLAY DEVICE**

(30) Priority: 19.03.2020 KR 20200033963
(71) Applicant: Samsung Display Co., Ltd., Yongin-si, Gyeonggi-Do 17113 (KR)
(72) Inventor: Bae, Chul Min, Hwaseong-si (KR); Lee, Ju Hyun, 82beon-gil, Bundang-gu, Seongnam-si (KR); Han, Ji Hye, A-303 Seoul (KR); Baek, Gyung Min, 67beon-gil, Suji-gu, Yongin-si (KR); Choi, Shin Il, Hwaseong-si (KR)
(74) Representative: Dr. Weitzel & Partner

(57) **Abstract**

A display device according to an embodiment includes: a substrate; a first compensation layer on the substrate; a buffer layer on the first compensation layer; a semiconductor layer on the buffer layer; a data wire including a source electrode and a drain electrode connected to the semiconductor layer; and a light-emitting device connected to the drain electrode, wherein the first compensation layer includes a SiNx, and a ratio of a N-H bond and a Si-H bond of the first compensation layer is 10 to 60.

## Description

### BACKGROUND

### (A) TECHNICAL FIELD

The present disclosure relates to a display device, and it particularly relates to a display device for preventing a display device from being bent by using a compensation layer.

### (B) DESCRIPTION OF THE RELATED ART

A display device displays images, and recently, a light emitting diode display has been given high attention as a self-light emitting diode display.

The light emitting diode display has a self-emitting characteristic, so it needs no additional light source, differing from a liquid crystal display device. By avoiding an additional light source, the light emitting diode display has reduced thickness and weight. Further, the light emitting diode display expresses high-quality characteristics such as low power consumption, high luminance, and high reaction speeds.

In general, the light emitting diode display includes a substrate, thin film transistors provided on the substrate, insulating layers disposed among wires configuring the thin film transistors, and a light-emitting device connected to the thin film transistors, and the light-emitting device may exemplarily be an organic light emitting element.

The wire may be thick so as to reduce resistance of the wire. However, when the wire becomes thick, the display device may be bent because of a characteristic of a metal included in the wire.

The above information disclosed in this Background section is only for enhancement of understanding of the background, and therefore it may contain information that does not form the prior art that is already known in this country to a person of ordinary skill in the art.

### SUMMARY

Embodiments have been made in an effort to provide a display device for preventing a display device from being bent.

An embodiment of the invention provides a display device including: a substrate; a buffer layer on the substrate; a semiconductor layer on the buffer layer; a data wire including a source electrode and a drain electrode connected to the semiconductor layer; and a light-emitting device connected to the drain electrode, at least a compensation layer which includes SiNx, and wherein a ratio of a N-H bond and a Si-H bond of the at least one compensation layer is 10 to 60 and/or a stress of the at least one compensation layer is -400 MPa to -1600 MP, and wherein the compensation layer or respectively a compensation layer is positioned between the substrate and the buffer layer and/or between the buffer layer and the semiconductor layer and/or directly or indirectly on an interlayer insulating layer, which is positioned on the semiconductor layer, and/or between an organic layer, which is positioned between the data wire and the light-emitting device, and the data wire.

An embodiment provides a display device including: a substrate; a first compensation layer on the substrate; a buffer layer on the first compensation layer; a semiconductor layer on the buffer layer; a data wire including a source electrode and a drain electrode connected to the semiconductor layer; and a light-emitting device connected to the drain electrode. The first compensation layer includes a SiNx, and a ratio of a N-H bond and a Si-H bond of the first compensation layer is 10 to 60.

A stress of the first compensation layer may be -400 MPa to -1600 MPa.

When used herein, the term stress may refer to the stress within the respective layer causing a bending force to the layer. Thus, the stress may comprise tensile stress within the plane direction of the layer, i.e. parallel the substrate. The stress may be a residual stress within the respective layer which is within the layer after manufacture and/or treatment of this layer. The stress may be such that an external bending force applied to the compensation layer, e.g. by another layer and/or wires directly or indirectly attached to the compensation layer, is compensated such that the compensation layer remains not bent, that is flat, despite the external bending force. To remain not bent or flat especially means that the maximum bending of the compensation layer is below a given allowable value, which is for example 1.1 mm or less, 1.04 mm or less, 0.5 mm or less, 0.46 mm or less, 0.18 mm or less, or 0.13 mm or less. The extend of bending may be measured as vertical distance from the lowest point of an upper surface of the compensation layer to the highest point of the upper surface of the compensation layer, or alternatively, from the highest point of the lower surface of the compensation layer to the lowest point of the lower surface of the compensation layer. Alternatively, the maximum allowable bending may be defined by means of a minimum radius of curvature of the upper surface or lower surface.

A thickness of the first compensation layer may be 100 nm (1000 Å) to 400 nm (4000 Å).

A hydrogen content of the first compensation layer may be equal to or less than 15 %. When used herein, the percentage (%) especially refers to at%, that is atomic %. Thus, for example, the percentage of the number of atoms of hydrogen in the first compensation layer relative to the total number of atoms in the first compensation layer may be equal or less than 15.

The semiconductor layer may include an oxide semiconductor, and the data wire may include copper.

A thickness of the data wire may be equal to or greater than 1000 nm (10,000 Å).

The display device may further include a second compensation layer between the buffer layer and the semiconductor layer, wherein a stress of the second compensation layer may be -400 MPa to -1600 MPa.

The second compensation layer may include a SiNx, a ratio of a N-H bond and a Si-H bond of the second compensation layer may be 10 to 60, and a hydrogen content of the second compensation layer may be equal to or less than 15 %.

The display device may further include: an interlayer insulating layer between the semiconductor layer and the data wire; and a third compensation layer between the interlayer insulating layer and the data wire, wherein the third compensation layer includes a SiNx, and a ratio of a N-H bond and a Si-H bond of the third compensation layer is 10 to 60.

A stress of the third compensation layer may be -400 MPa to -1600 MPa, and a hydrogen content of the third compensation layer may be equal to or less than 15 %.

The display device may further include: an organic layer between the data wire and the light-emitting device; and a fourth compensation layer between the organic layer and the data wire, wherein the fourth compensation layer may include a SiNx, and a hydrogen content of the fourth compensation layer may be equal to or less than 15 %.

The display device may further include: an interlayer insulating layer between the semiconductor layer and the data wire; and a third compensation layer between the interlayer insulating layer and the data wire, wherein the third compensation layer may include a SiNx, a stress of the third compensation layer may be -400 MPa to -1600 MPa, and a hydrogen content of the third compensation layer may be equal to or less than 15 %.

The display device may further include: an organic layer between the data wire and the light-emitting device; and a fourth compensation layer between the organic layer and the data wire, wherein the fourth compensation layer may include a SiNx, and a ratio of a N-H bond and a Si-H bond of the fourth compensation layer may be 10 to 60.

The display device may further include: an organic layer between the data wire and the light-emitting device; and a fourth compensation layer between the organic layer and the data wire, wherein a stress of the fourth compensation layer may be -400 MPa to -1600 MPa.

An embodiment provides a display device including: a substrate; a buffer layer on the substrate; a second compensation layer on the buffer layer; a semiconductor layer on the second compensation layer; a data wire including a source electrode and a drain electrode connected to the semiconductor layer; and a light-emitting device connected to the drain electrode. The second compensation layer may include a SiNx, a stress of the second compensation layer may be -400 MPa to -1600 MPa, and a hydrogen content of the second compensation layer may be equal to or less than 15 %.

A ratio of a N-H bond and a Si-H bond of the second compensation layer may be 10 to 60, and a thickness of the second compensation layer may be 100 nm (1000 Å) to 300 nm (3000 Å).

The display device may further include: an interlayer insulating layer between the semiconductor layer and the data wire; and a third compensation layer between the interlayer insulating layer and the data wire, wherein the third compensation layer may include a SiNx, a ratio of a N-H bond and a Si-H bond of the second compensation layer may be 10 to 60, and a hydrogen content of the third compensation layer may be equal to or less than 15 %.

The display device may further include: an organic layer between the data wire and the light-emitting device; and a fourth compensation layer between the organic layer and the data wire, wherein a ratio of a N-H bond and a Si-H bond of the fourth compensation layer may be 10 to 60.

The display device may further include: an organic layer between the data wire and the light-emitting device; and a fourth compensation layer between the organic layer and the data wire, wherein the fourth compensation layer may include a SiNx, a stress of the fourth compensation layer may be -400 MPa to -1600 MPa, and a hydrogen content of the fourth compensation layer may be equal to or less than 15 %.

An embodiment provides a display device including: a substrate; a buffer layer on the substrate; a semiconductor layer on the buffer layer; an interlayer insulating layer on the semiconductor layer; a third compensation layer on the interlayer insulating layer; a data wire including a source electrode and drain electrode on the third compensation layer and connected to the semiconductor layer; and a light-emitting device connected to the drain electrode. A ratio of a N-H bond and a Si-H bond of the third compensation layer may be 10 to 60, and a stress of the third compensation layer may be -400 MPa to -1600 MPa.

The third compensation layer may include a SiNx, and a hydrogen content of the third compensation layer may be equal to or less than 15 %.

The display device may further include: an organic layer between the data wire and the light-emitting device; and a fourth compensation layer between the organic layer and the data wire, wherein the fourth compensation layer may include a SiNx, and a ratio of a N-H bond and a Si-H bond of the fourth compensation layer may be 10 to 60.

According to the embodiments, the display device for preventing the display device from being bent is provided by using the compensation layer.

### BRIEF DESCRIPTION OF THE DRAWINGS

FIG. 1 shows a cross-sectional view of a display device according to an embodiment.
FIG. 2 shows a configuration in which a display device is bent by a thick source drain wire.
FIG. 3 shows a result of measuring average bending of a case including a first compensation layer and a case including no first compensation layer while changing a thickness of a wire.
FIG. 4 shows a result of measuring average bending with respect to a thickness of a wire while varying a thickness of a first compensation layer.
FIG. 5 shows a result of measuring a stress value according to a ratio of N-H/Si-H of a film of a SiNx.
FIG. 6 shows a result of measuring thermal stability of a N-H bond and a Si-H bond.
FIG. 7 shows a cross-sectional view of a display device according to an embodiment similar to that of FIG. 1.
FIG. 8 shows a cross-sectional view of an embodiment similar to that of FIG. 1.
FIG. 9 shows a result of measuring a bending degree with respect to a position of a compensation layer while allowing a thickness of a data wire to be 1100 nm (11,000 Å) according to the embodiment of FIG. 7 and FIG. 8.
FIG. 10 shows a cross-sectional view of a display device according to an embodiment similar to that of FIG. 1.
FIG. 11 shows a cross-sectional view of a display device according to an embodiment similar to that of FIG. 1.
FIG. 12 shows a cross-sectional view of a display device according to an embodiment similar to that of FIG. 1.
FIG. 13 shows a cross-sectional view of a display device according to an embodiment similar to that of FIG. 10.
FIG. 14 shows a cross-sectional view of a display device according to an embodiment similar to that of FIG. 11.
FIG. 15 shows a cross-sectional view of a display device according to an embodiment similar to that of FIG. 13.
FIG. 16 shows a cross-sectional view of a display device according to an embodiment similar to that of FIG. 7.
FIG. 17 shows a cross-sectional view of a display device according to an embodiment similar to that of FIG. 7.
FIG. 18 shows a cross-sectional view of a display device according to an embodiment similar to that of FIG. 16.
FIG. 19 shows a cross-sectional view of a display device according to an embodiment similar to that of FIG. 8.
FIG. 20 shows a circuit diagram of a pixel of a display device according to an embodiment.
FIG. 21 shows a planar layout view of pixels PX1, PX2, and PX3 of a display device according to an embodiment.
FIG. 22 shows a cross-sectional view of the display device shown in FIG. 21 along the line XX-XX'.
FIG. 23 shows a cross-sectional view of the display device shown in FIG. 21 along the lines XXI-XXI' and XXII-XXII'.

### DETAILED DESCRIPTION

The inventive concept will be described more fully hereinafter with reference to the accompanying drawings, in which embodiments are shown. As those skilled in the art would realize, the described embodiments may be modified in various different ways, all without departing from the scope of the claims.

The drawings and description are to be regarded as illustrative in nature and not restrictive, and like reference numerals designate like elements throughout the specification.

The size and thickness of each configuration shown in the drawings are arbitrarily shown for better understanding and ease of description. In the drawings, the thickness of layers, films, panels, areas, etc., are exaggerated for clarity. For better understanding and ease of description, the thicknesses of some layers and areas are exaggerated.

It will be understood that when an element such as a layer, film, area, or substrate is referred to as being "on" another element, it can be directly on the other element or intervening elements may also be present. In contrast, when an element is referred to as being "directly on" another element, there are no intervening elements present. Further, in the specification, the word "on" or "above" means positioned on or above the object portion, and does not necessarily mean positioned on the upper side of the object portion based on a gravitational direction.

Unless explicitly described to the contrary, the word "comprise" and variations such as "comprises" or "comprising" will be understood to imply the inclusion of stated elements but not the exclusion of any other elements.

The phrase "in a plan view" means viewing the object portion from the top, and the phrase "in a cross-sectional view" means viewing a cross-section of which the object portion is vertically cut from the side.

A display device according to an embodiment will now be described with reference to accompanying drawings.

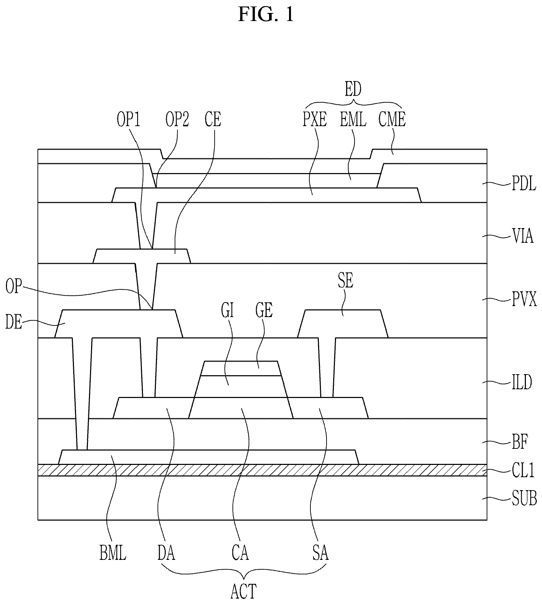

FIG. 1 shows a cross-sectional view of a display device according to an embodiment. FIG. 1 simplifies part of the cross-section for better comprehension and ease of description

Referring to FIG. 1, a substrate SUB is positioned. The substrate SUB may include plastic or glass.

A first compensation layer CL1 may be positioned on the substrate SUB. The first compensation layer CL1 may include a SiNx, where x may be 1 to 4. A ratio, hereinafter, N-H/Si-H, of a N-H bond and a Si-H bond in the first compensation layer CL1 may be equal to or greater than 10. Suitably, the ratio may be 10 to 60. The ratio of N-H/Si-H represents a range for the first compensation layer CL1 to have a negative stress value. To be separately described in a later portion of the present specification, the phenomenon in which the display device is bent when the wire is formed to be thick may be prevented by the first compensation layer CL1 with a negative stress value. When the value of N-H/Si-H is less than 10, the first compensation layer CL1 may be insufficient in preventing the display device from being bent. When the value is greater than 60, the stress value excessively increases, so the display device may be bent in an opposite direction.

In the present embodiment, to minimize an influence for the compensation layer to give to elements, a hydrogen content of the first compensation layer CL1 may be equal to or less than 15 %. When the hydrogen content of the first compensation layer CL1 is greater than 15 %, the hydrogen may influence performance of a transistor.

A stress of the first compensation layer CL1 may be -400 MPa to -1600 MPa. When the stress of the first compensation layer CL1 is less than -400 MPa, it may be insufficient in preventing the display device from being bent. When the absolute value of the stress of the first compensation layer CL1 is greater than 1600 MPa (that is the stress is smaller than -1600 MPa), the negative stress value may be excessively large and the display device may be bent in the opposite direction.

When the first compensation layer CL1 includes the SiNx with the ratio of N-H/Si-H that is equal to or greater than 10, the first compensation layer CL1 has a negative stress. By providing the first compensation layer CL1 with a negative stress, the display device may be prevented from being bent when the thickness of the wire such as a data line in the display device increases. A detailed effect will be described in a later part of the present specification.

A thickness of the first compensation layer CL1 may be 100 nm (1000 Å) to 400 nm (4000 Å). When the thickness of the first compensation layer CL1 is less than 100 nm (1000 Å), it may be insufficient in suppressing the bending of the display device. When the thickness of the first compensation layer CL1 is greater than 400 nm (4000 Å), the transistor may be influenced by the hydrogen included in the first compensation layer CL1.

Referring to FIG. 1, a light blocking layer BML is positioned on the first compensation layer CL1. The light blocking layer BML stops external light from reaching a channel area CA of a semiconductor layer ACT. By stopping external light from reaching the channel area CA of the semiconductor layer ACT, the light blocking layer BML reduces a leakage current and characteristic deterioration. The light blocking layer BML may be electrically connected to a drain electrode DE.

A buffer layer BF is positioned on the light blocking layer BML. The buffer layer BF may include an inorganic insulating material, such as a silicon nitride (SiNx), a silicon oxide (SiOx), or a silicon oxynitride (SiON), and/or an organic insulating material. The x is 1 to 4.

The semiconductor layer ACT is positioned on the buffer layer BF. The semiconductor layer ACT includes a source area SA, the channel area CA, and a drain area DA. The semiconductor layer ACT may include one of amorphous silicon, polycrystalline silicon, monocrystalline silicon, and an oxide semiconductor. In an embodiment, the semiconductor layer ACT may include an oxide semiconductor.

The source area SA of the semiconductor layer ACT is connected to a source electrode SE, and the drain area DA is connected to the drain electrode DE. The source electrode SE and the drain electrode DE may include copper. The source electrode SE and the drain electrode DE may have a thickness that is equal to or greater than 1000 nm (10,000 Å). To be described hereinafter, the thicknesses of the source electrode SE and the drain electrode DE are equal to or greater than 1000 nm (10,000 Å), the thicknesses reducing resistance of the wire.

An interlayer insulating layer ILD may be positioned on the semiconductor layer ACT. The interlayer insulating layer ILD may include a silicon nitride (SiNx), a silicon oxide (SiOx), or a silicon oxynitride (SiON). The interlayer insulating layer ILD may be a multilayer including a silicon nitride (SiNx), a silicon oxide (SiOx), or a silicon oxynitride (SiON)

A gate insulating pattern GI may overlap the channel area CA of the semiconductor layer ACT. The gate insulating pattern GI may not substantially overlap a conductive area of the semiconductor layer ACT.

A gate electrode GE may be positioned on the gate insulating pattern GI. The gate electrode GE may overlap the channel area CA of the semiconductor layer ACT and the substrate SUB in a perpendicular direction. The gate electrode GE, the semiconductor layer ACT, the source electrode SE, and the drain electrode DE configure a transistor.

Referring to FIG. 1, an intermediate layer PVX may be positioned on the source electrode SE and the drain electrode DE. The intermediate layer PVX may include an opening OP, and a connection electrode CE may contact the drain electrode DE in the opening OP. An organic layer VIA may be positioned on the connection electrode CE. The organic layer VIA may include an organic material. The organic layer VIA may include an opening OP1, and a first electrode PXE may contact the connection electrode CE in the opening OP1.

That is, FIG. 1 shows an embodiment in which the drain electrode DE is connected to the first electrode PXE through the connection electrode CE. This is, however, an example, and in an embodiment, the connection electrode CE is omitted and the drain electrode DE and the first electrode PXE are directly connected to each other.

A partition wall PDL may be positioned on the first electrode PXE. An emission layer EML may be positioned in an opening OP2 in the partition wall PDL. A second electrode CME may be positioned on the emission layer EML. The first electrode PXE, the emission layer EML, and the second electrode CME configure a light-emitting device ED.

Referring to FIG. 1, regarding the display device according to an embodiment, the source electrode SE and the drain electrode DE are positioned on one layer. That is, the source electrode SE and the drain electrode DE are positioned on a single layer. In this instance, the positioning on a single layer does not mean that the source electrode and the drain electrode are made of one material, but it means that there is no insulating layer positioned between the source electrodes (or the drain electrodes). That is, this signifies that the source electrodes (or the drain electrodes) are on respective sides with the insulating layer between the source electrodes (or the drain electrodes) and are not connected to each other.

To reduce resistance, the source electrode SE and the drain electrode DE may be thick. For example, the source electrode SE and the drain electrode DE may be 400 nm (4000 Å) to 700 nm (7000 Å) thick in the configuration in which the source electrode SE and the drain electrode DE are positioned on different layers and are connected to the source electrode SE and the drain electrode DE on different layers through an interlayer opening.

However, as shown in FIG. 1, the respective electrodes may be equal to or greater than 1000 nm (10,000 Å) thick when the source electrode SE and the drain electrode DE are positioned on one layer. This is because a sum of thicknesses of the source electrodes (or drain electrodes) on the respective layers influences resistance in the configuration in which the source electrodes (or drain electrodes) on the multiple layers are connected to each other through an opening, and a thickness of the source electrode on one layer influences resistance in the configuration in which the source electrode is on a single layer. Therefore, the thickness of the source electrode in the configuration in which the source electrode is on a single layer must be greater than the thickness of the source electrode in the configuration in which the source electrodes are on the multiple layers.

That is, regarding the display device according to an embodiment described with reference to FIG. 1, resistance of the wire may be reduced by allowing the thickness of the electrode to be equal to or greater than 1000 nm (10,000 Å) instead of positioning of the source electrode SE and the drain electrode DE on a single layer. The above-noted configuration in which the source electrode SE and the drain electrode DE are on a single layer may simplify the process, compared to the configuration in which the source electrodes SE or drain electrodes DE positioned on different layers are connected to each other.

However, in this case, the thickness of the single electrode increases to be equal to or greater than 1000 nm (10,000 Å), so the display device may be bent. Particularly, when the data wire, that is the source electrode DE or the drain electrode, includes copper, the display device may be bent by the characteristic that the copper contracts.

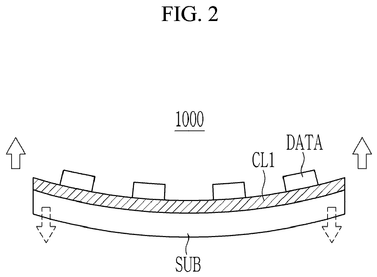

FIG. 2 shows a configuration in which a display device 1000 is bent by a thick source drain wire. The display device shown in FIG. 2 is simply illustrated with the configuration including a substrate SUB, a data wire DATA including a source electrode and a drain electrode, and a first compensation layer CL1.

As shown in FIG. 2, the display device 1000 may be bent so that its edge lifts upward from the ground by a contracting characteristic of the data wire DATA with the thickness that is equal to or greater than 1000 nm (10,000 Å). In this instance, the direction in which the display device 1000 is bent is shown with an arrow (in a solid line). That is, when the thickness of the data wire DATA is 1000 nm (10,000 Å), the display device 1000 may be bent as shown in FIG. 2 according to the contracting characteristic of the metal.

However, the display device according to the present embodiment includes the first compensation layer CL1, which prevents the display device 1000 including a thick data wire DATA from being bent.

The first compensation layer CL1 according to the present embodiment has a negative stress value. Having a negative stress value signifies that the first compensation layer CL1 is bent in a direction shown by a dotted arrow direction in FIG. 2. Therefore, a force works in an opposite direction (indicated by a dotted arrow) to the direction (solid line arrow) in which the display device 1000 is bent by the data wire DATA, so the two forces are offset to thus prevent the display device 1000 from being bent.

Features of the inventive concept will now be described by a detailed experimental example.

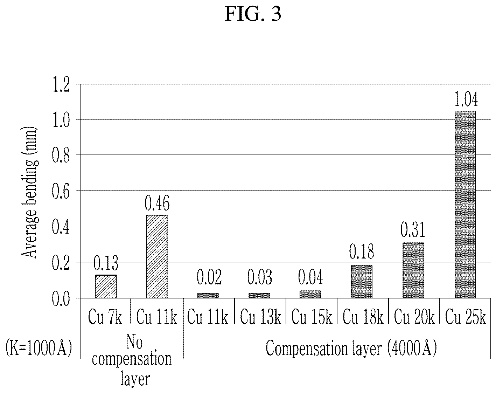

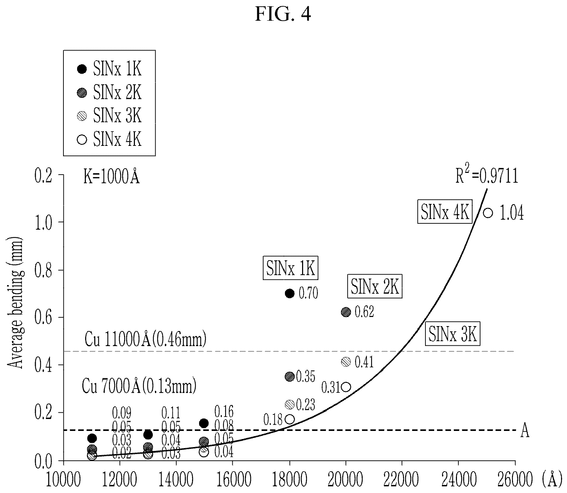

FIG. 3 shows a result of measuring average bending of a case including a first compensation layer and a case including no first compensation layer while changing a thickness of a wire. Here, the thickness of the first compensation layer is set to be 400 nm (4000 Å) in the present experiment. The thickness of the wire is labeled with "Cu", also in FIG. 4.

Referring to the left part of FIG. 3, in the case of the experimental example having no compensation layer, it is bent by 0.13 mm when the wire is 700 nm (7000 Å) thick, and it is bent by 0.46 mm when the wire is 1100 nm (11,000 Å) thick. Referring to the right part of FIG. 3, in the case of the experimental example having a compensation layer, the average bending is 0.04 mm when the wire reaches 1500 nm (15,000 Å) thick, which is very minor value.

FIG. 4 shows a result of measuring average bending (vertical axis) with respect to a thickness (horizontal axis) of a wire while varying the thickness of a first compensation layer to 100 nm (1000 Å), 200 nm (2000 Å), 300 nm (3000 Å), and 400 nm (4000 Å). The area shown with dotted lines in FIG. 4 represents a limit value of maximum allowable bending in the process for manufacturing a display device. Referring to FIG. 4, it is found that a bending control effect is provided when the first compensation layer is less than 400 nm (4000 Å) thick.

When the number marked with the dotted line A in FIG. 4 is given as the bending number allowable by the display device, and the first compensation layer is set to be 100 nm (1000 Å) thick, the wire may be formed to be 1400 nm (14,000 Å) thick at a maximum. It is found that the wire may be formed to be 1500 nm (15,000 Å) thick at a maximum when the first compensation layer is set to be 200 nm (2000 Å) thick, the wire may be formed to be 1600 nm (16,000 Å) thick at a maximum when the first compensation layer is set to be 300 nm (3000 Å) thick, and the wire may be formed to be 1800 nm (18,000 Å) thick when the first compensation layer is set to be 400 nm (4000 Å) thick at a maximum. The dotted line A in FIG. 4 shows an exemplary allowable bending of 0.13 mm of the display device, especially the first compensation layer CL1 (or the substrate SUB), and the second dotted line shows another exemplary allowable bending of 0.46 mm of the display device, especially the first compensation layer CL1 (or the substrate SUB), respectively corresponding to the bending values shown in FIG. 3, when no compensation layer is provided. However, other maximum allowable bending values may be selected.

The ratio of N-H/Si-H of the first compensation layer CL1 may be equal to or greater than 10. The ratio of N-H/Si-H may suitably be 10 to 60. The ratio of N-H/Si-H represents a composition range for the first compensation layer CL1 to have a negative stress value. The display device is prevented from being bent by the first compensation layer CL1 with a negative stress value.

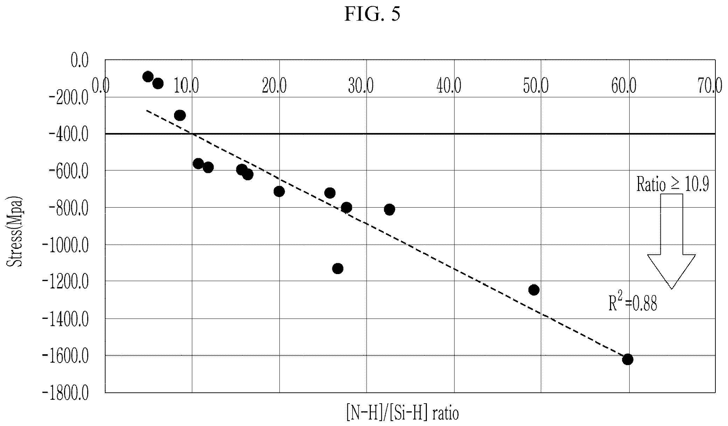

FIG. 5 shows a result of measuring a stress value according to a ratio of N-H/Si-H of a film of a SiNx. Referring to FIG. 5, regarding the display device according to the present embodiment, when the ratio of N-H/Si-H is equal to or greater than 10, the first compensation layer CL1 has a stress value that is equal to or less than -400 MPa. The stress value represents a numerical value for preventing the display device from being bent.

A hydrogen content of the first compensation layer CL1 may be equal to or less than 15 %. Hence, the first compensation layer CL1 may not influence performance of the transistor.

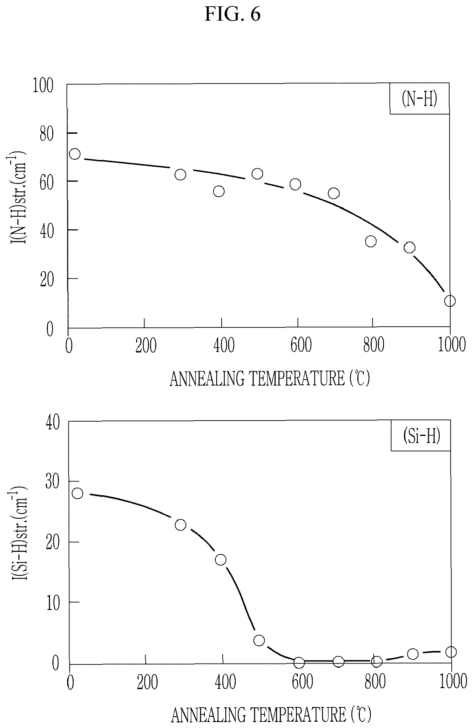

FIG. 6 shows a result of measuring thermal stability of a N-H bond and a Si-H bond. As can be found with reference to FIG. 6, thermal stability of the N-H bond is higher than thermal stability of the Si-H bond. Therefore, according to the present embodiment in which the ratio of N-H/Si-H is equal to or greater than 10, the number of N-H bonds with excellent thermal stability is the majority, so the hydrogen is not easily separated and the influence of the hydrogen to the transistor may be prevented.

As described above, regarding the display device according to an embodiment, the first compensation layer CL1 is positioned on the substrate SUB, and the first compensation layer CL1 includes SiNx, its ratio of N-H/Si-H is equal to or greater than 10, and it has a negative stress value. Therefore, when the data wire including a source and a drain is formed to be thicker than 1000 nm (10,000 Å), the display device may not be bent, resistance of the data wire may be reduced according to a simple process, and the display device may be prevented from being bent. The data wire has been exemplified in the above, and the effect for preventing the first compensation layer CL1 from being bent is the same as the case when other wires are given to be thick.

A display device according to an embodiment will now be described with reference to accompanying drawings.

An embodiment in which the first compensation layer CL1 is positioned between the substrate SUB and the light blocking layer BML has been described with reference to FIG. 1, and the compensation layer may be positioned in other areas according to various embodiments.

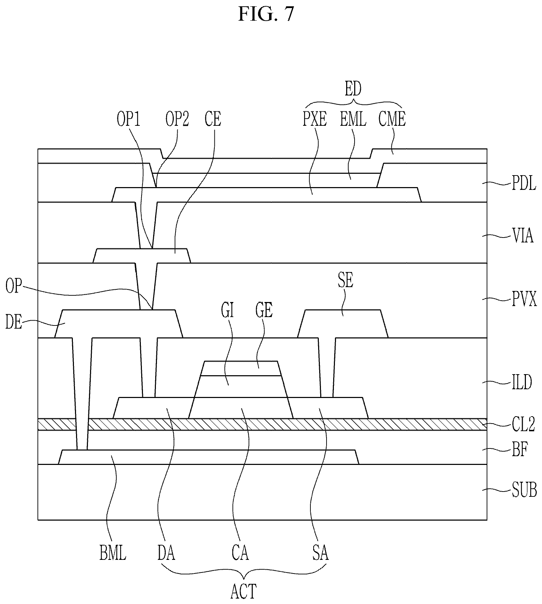

FIG. 7 shows a cross-sectional view of a display device according to an embodiment similar to that of FIG. 1. Referring to FIG. 7, the display device according to the present embodiment may include a second compensation layer CL2 between a buffer layer BF and a semiconductor layer ACT instead of the first compensation layer CL1 described with reference to FIG. 1.

The thickness of the second compensation layer CL2 may be equal to or less than 300 nm (3000 Å). This is because, differing from the first compensation layer CL1, the second compensation layer CL2 contacts the buffer layer BF including a SiOx, so when the second compensation layer CL2 including a SiNx becomes thick, the possibility that hydrogen may be input into the semiconductor layer ACT increases.

The description on the material of the second compensation layer CL2 is identical to that of the first compensation layer CL1. That is, the second compensation layer CL2 includes a SiNx, its ratio of N-H/Si-H is equal to or greater than 10, and it has a negative stress value. In detail, the stress of the second compensation layer CL2 may be - 400 MPa to -1600 MPa. The hydrogen content of the second compensation layer CL2 may be equal to or less than 15 %. Therefore, the second compensation layer CL2 may prevent the display device from being bent when the data wire is formed to be equal to or greater than 1000 nm (10,000 Å) thick, and it may not influence the characteristic of the transistor as the hydrogen content in the film is equal to or less than 15 %.

Referring to FIG. 7, the buffer layer BF may include a SiNx. In this case, the second compensation layer CL2 is part of the buffer layer BF and it may function as the buffer layer BF. When the buffer layer BF and the second compensation layer CL2 includes the SiNx, film quality of the SiNx included in the buffer layer BF may be different from film quality of the SiNx included in the second compensation layer CL2. That is, the SiNx included in the second compensation layer CL2 may have the ratio of N-H/Si-H that is equal to or greater than 10, as described above.

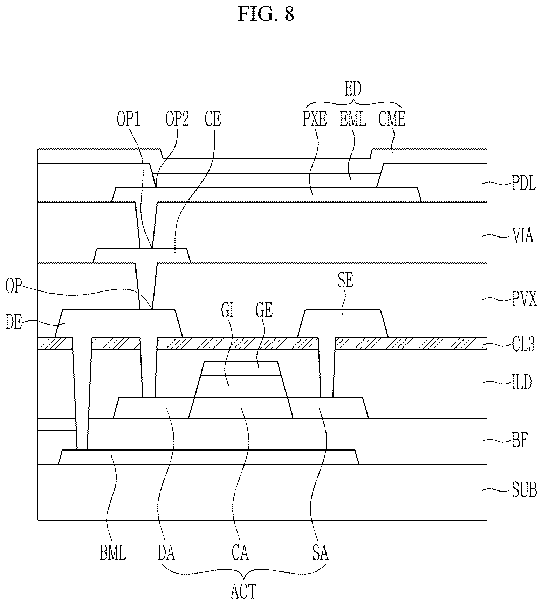

FIG. 8 shows a cross-sectional view of an embodiment similar to that of FIG. 1. Referring to FIG. 8, the display device according to the present embodiment may include a third compensation layer CL3 between an interlayer insulating layer ILD and an intermediate layer PVX, instead of the first compensation layer CL1 shown in FIG. 1.

The thickness of the third compensation layer CL3 may be equal to or less than 300 nm (3000 Å). This is because, differing from the first compensation layer CL1, the third compensation layer CL3 contacts the interlayer insulating layer ILD including a SiOx, so when the third compensation layer CL3 including a SiNx becomes thick, the possibility that hydrogen may be input into the semiconductor layer ACT increases.

The description on the material of the third compensation layer CL3 is identical to that of the first compensation layer CL1. That is, the third compensation layer CL3 includes a SiNx, its ratio of N-H/Si-H is equal to or greater than 10, and it has a negative stress value. In detail, the stress of the third compensation layer CL3 may be -400 MPa to -1600 MPa. The hydrogen content of the third compensation layer CL3 may be equal to or less than 15 %. Therefore, the third compensation layer CL3 may prevent the display device from being bent when the data wire is formed to be equal to or greater than 1000 nm (10,000 Å) thick, and it may not influence the characteristic of the transistor as the hydrogen content in the film is equal to or less than 15 %.

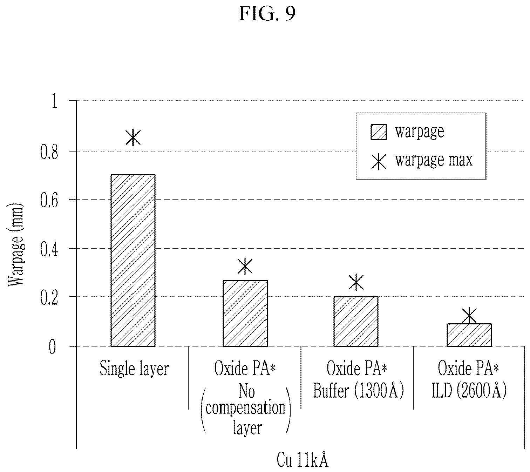

FIG. 9 shows a result of measuring a bending degree with respect to a position of a compensation layer while allowing a thickness of a data wire to be 1100 nm (11,000 Å) according to the embodiments of FIG. 7 and FIG. 8. Referring to FIG. 9, the display device is substantially bent when including no compensation layer. However, it is found that the display device is less bent according to an experimental example including a second compensation layer CL2 (which is on the buffer layer and has a thickness of 130 nm (1300 Å) mentioned in FIG. 9) or an experimental example including a third compensation layer CL3 (which is on the ILD and has a thickness of 260 nm (2600 Å) mentioned in FIG. 9).

That is, it is found that the display device is prevented from being bent when it includes a second compensation layer CL2 or a third compensation layer CL3 in addition to the first compensation layer CL1.

An embodiment including one of the first compensation layer CL1, the second compensation layer CL2, and the third compensation layer CL3 has been described, but several compensation layers are allowable.

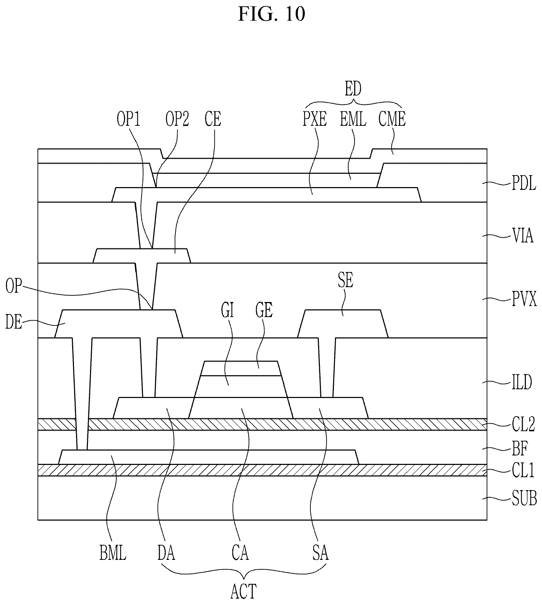

FIG. 10 shows a cross-sectional view of a display device according to an embodiment similar to that of FIG. 1. Referring to FIG. 10, the display device according to the present embodiment is identical to the embodiment described with reference to FIG. 1, except that it includes the first compensation layer CL1 and the second compensation layer CL2. Descriptions on the material and the thickness of the first compensation layer CL1 and the second compensation layer CL2 also are identical to the above-provided descriptions. No detailed description of the same constituent elements will be provided.

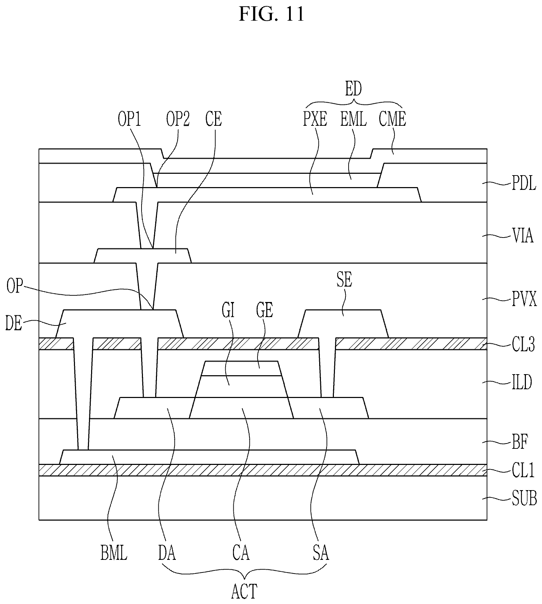

FIG. 11 shows a cross-sectional view of a display device according to an embodiment similar to that of FIG. 1. Referring to FIG. 11, the display device according to the present embodiment is identical to the embodiment described with reference to FIG. 1, except that it includes the first compensation layer CL1 and the third compensation layer CL3. Descriptions of the material and the thickness of the first compensation layer CL1 and the third compensation layer CL3 also are identical to the above-provided descriptions. No detailed description of the same constituent elements will be provided.

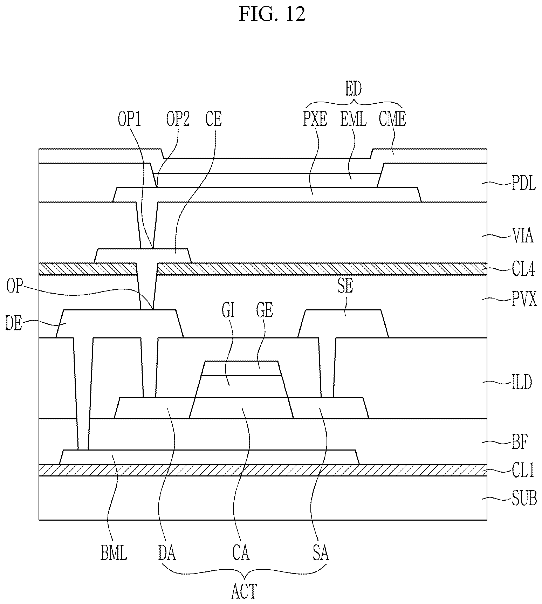

FIG. 12 shows a cross-sectional view of a display device according to an embodiment similar to that of FIG. 1. Referring to FIG. 12, the display device according to the present embodiment is identical to an embodiment described with reference to FIG. 1, except that it includes the first compensation layer CL1 and a fourth compensation layer CL4. Descriptions of the material and the thickness of the first compensation layer CL1 also is identical to the above-provided descriptions. No detailed description of the same constituent elements will be provided.

The fourth compensation layer CL4 may be positioned between the intermediate layer PVX and the organic layer VIA. Descriptions on the fourth compensation layer CL4 correspond to those of the first compensation layer CL1. That is, the fourth compensation layer CL4 includes a SiNx, its ratio of N-H/Si-H is equal to or greater than 10, and it has a negative stress value. In detail, the stress of the fourth compensation layer CL4 may be -400 MPa to -1600 MPa. The hydrogen content of the fourth compensation layer CL4 may be equal to or less than 15 %. The fourth compensation layer CL4 may be 100 nm (1000 Å) to 400 nm (4000 Å) thick.

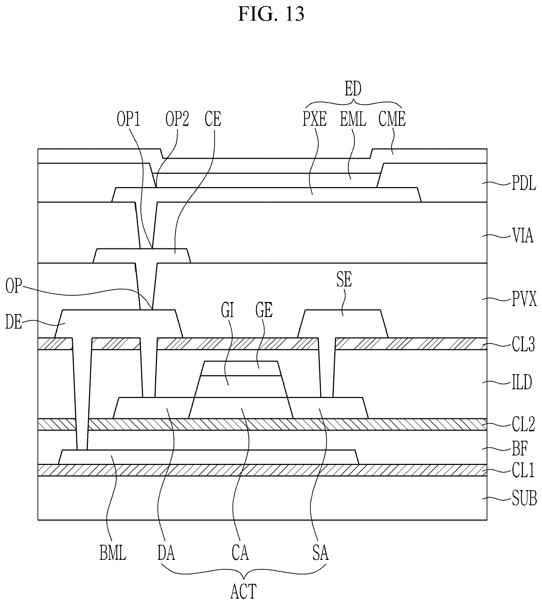

FIG. 13 shows a cross-sectional view of a display device according to an embodiment similar to that of FIG. 10. Referring to FIG. 13, the display device according to the present embodiment is identical to an embodiment described with reference to FIG. 10, except that it further includes a third compensation layer CL3 in addition to the first compensation layer CL1 and the second compensation layer CL2. The materials and the thicknesses of the first compensation layer CL1, the second compensation layer CL2, and the third compensation layer CL3 correspond to those of the above-provided descriptions. No detailed description of the same constituent elements will be provided.

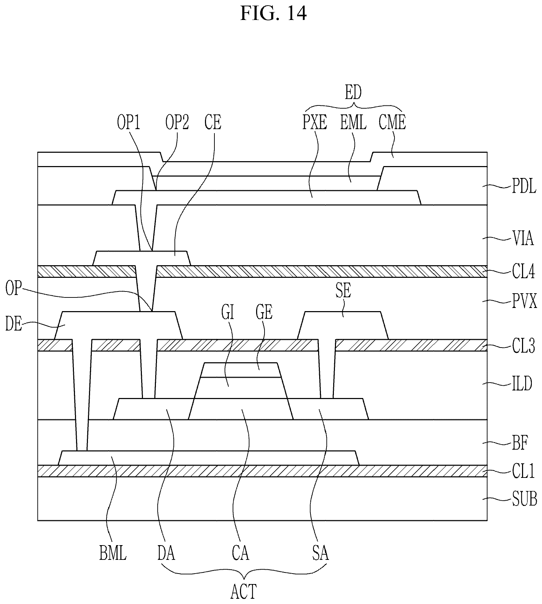

FIG. 14 shows a cross-sectional view of a display device according to an embodiment similar to that of FIG. 11. Referring to FIG. 14, the display device according to the present embodiment is identical to an embodiment described with reference to FIG. 11, except that it further includes a fourth compensation layer CL4 in addition to the first compensation layer CL1 and the third compensation layer CL3. The materials and the thicknesses of the first compensation layer CL1, the third compensation layer CL3, and the fourth compensation layer CL4 correspond to those of the above-provided descriptions. No detailed description of the same constituent elements will be provided.

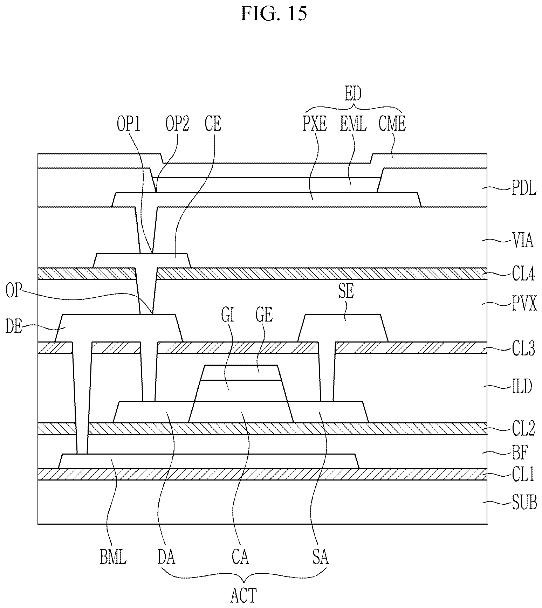

FIG. 15 shows a cross-sectional view of a display device according to an embodiment similar to that of FIG. 13. Referring to FIG. 15, the display device according to the present embodiment is identical to an embodiment described with reference to FIG. 13, except that it further includes a fourth compensation layer CL4 in addition to the first compensation layer CL1, the second compensation layer CL2, and the third compensation layer CL3. The materials and the thicknesses of the first compensation layer CL1, the second compensation layer CL2, the third compensation layer CL3, and the fourth compensation layer CL4 correspond to those of the above-provided descriptions. No detailed description of the same constituent elements will be provided.

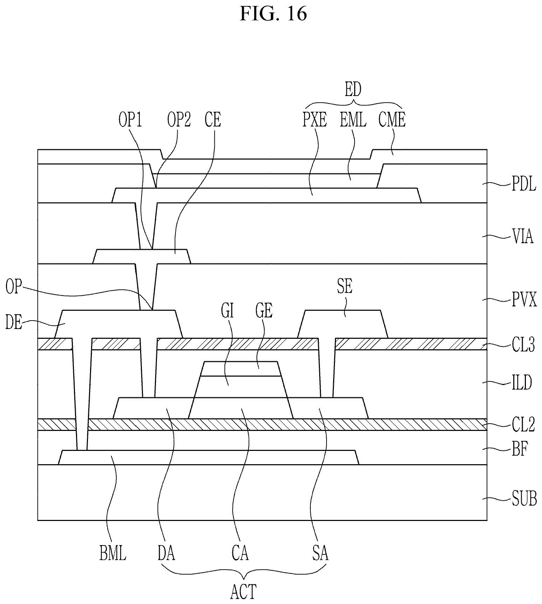

FIG. 16 shows a cross-sectional view of a display device according to an embodiment similar to that of FIG. 7. Referring to FIG. 16, the display device according to the present embodiment is identical to an embodiment described with reference to FIG. 7, except that it further includes a third compensation layer CL3 in addition to the second compensation layer CL2. The materials and the thicknesses of the second compensation layer CL2 and the third compensation layer CL3 correspond to those of the above-provided descriptions. No detailed description of the same constituent elements will be provided.

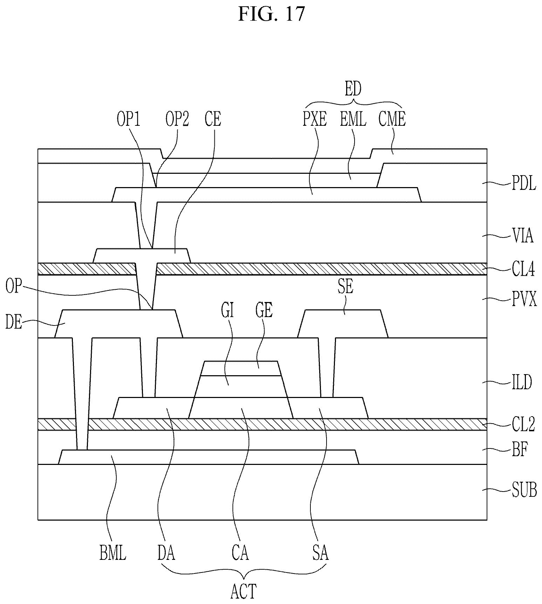

FIG. 17 shows a cross-sectional view of a display device according to an embodiment similar to that of FIG. 7. Referring to FIG. 17, the display device according to the present embodiment is identical to an embodiment described with reference to FIG. 7, except that it further includes a fourth compensation layer CL4 in addition to the second compensation layer CL2. The materials and the thicknesses of the second compensation layer CL2 and the fourth compensation layer CL4 correspond to those of the above-provided descriptions. No detailed description of the same constituent elements will be provided.

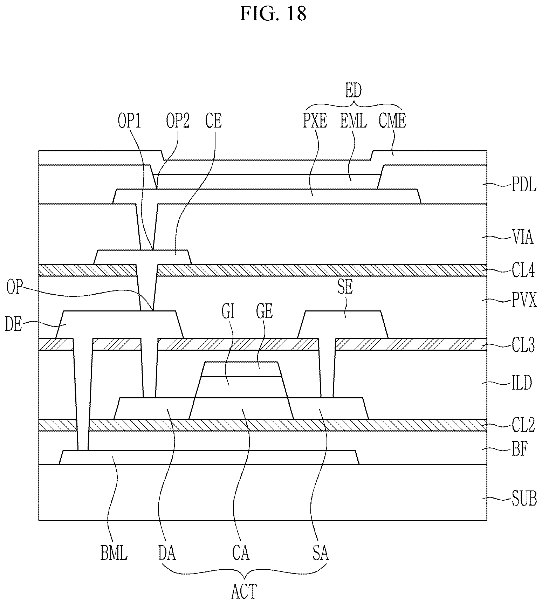

FIG. 18 shows a cross-sectional view of a display device according to an embodiment similar to that of FIG. 16. Referring to FIG. 18, the display device according to the present embodiment is identical to an embodiment described with reference to FIG. 16, except that it further includes a fourth compensation layer CL4 in addition to the second compensation layer CL2 and the third compensation layer CL3. The materials and the thicknesses of the second compensation layer CL2, the third compensation layer CL3, and the fourth compensation layer CL4 correspond to those of the above-provided descriptions. No detailed description of the same constituent elements will be provided.

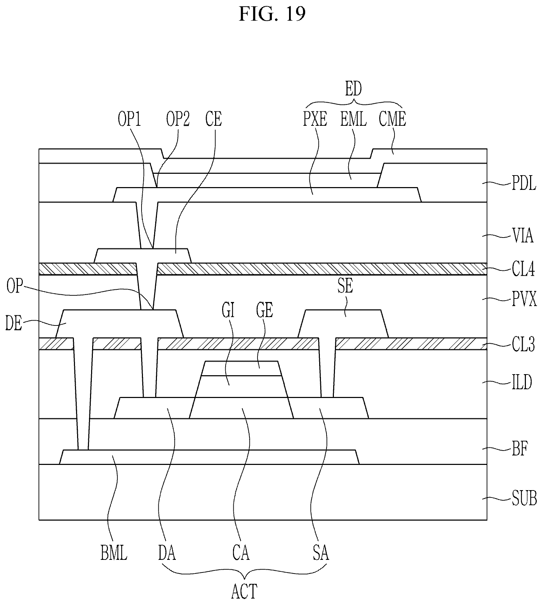

FIG. 19 shows a cross-sectional view of a display device according to an embodiment similar to that of FIG. 8. Referring to FIG. 19, the display device according to the present embodiment is identical to an embodiment described with reference to FIG. 8, except that it further includes a fourth compensation layer CL4 in addition to the third compensation layer CL3. The materials and the thicknesses of the third compensation layer CL3 and the fourth compensation layer CL4 correspond to those of the above-provided descriptions. No detailed description of the same constituent elements will be provided.

The display device according to an embodiment as described above further includes a compensation layer in the display device. The compensation layer prevents the display device from being bent when the data wire is formed to be thick. The compensation layer includes a SiNx, its ratio of N-H/Si-H is equal to or greater than 10, it has a negative stress value of -400 MPa to -1600 MPa, and its hydrogen content may be equal to or less than 15 %. Therefore, when the wire in the display device is formed to be equal to or greater than 1000 nm (10,000 Å) thick, the display device may be prevented from being bent, and the hydrogen content in the compensation layer is small, so it may not influence performance of the transistor.

An embodiment has been described with respect to the cross-sections of the display device. The cross-sections are given for ease of descriptions.

A display device according to an embodiment will now be described by exemplifying a configuration as an example. The configuration to be described hereinafter is, however, only an example.

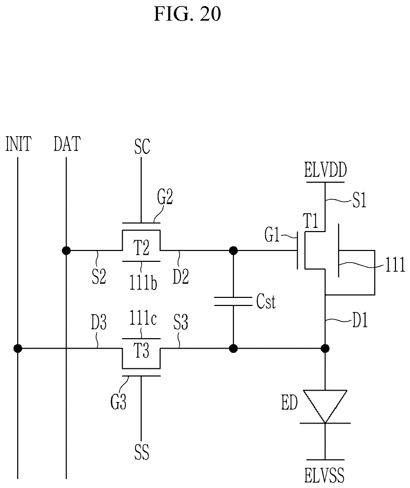

FIG. 20 shows a circuit diagram of a pixel of a display device according to an embodiment.

Referring to FIG. 20, the display device according to an embodiment includes pixels, and one pixel may include transistors T1, T2, and T3, a capacitor Cst, and at least one light emitting diode ED. In the present embodiment, the one pixel will be generally exemplified to include one light emitting diode ED.

Transistors T1, T2, and T3 include a first transistor T1, a second transistor T2, and a third transistor T3. A source electrode and a drain electrode to be described are given to distinguish two electrodes on respective sides of channels of the transistors T1, T2, and T3, and they are exchangeable with each other.

A gate electrode G1 of the first transistor T1 is connected to a first end of the capacitor Cst, a source electrode S1 of the first transistor T1 is connected to a driving voltage line for transmitting a driving voltage ELVDD, and a drain electrode D1 of the first transistor T1 is connected to an anode of the light emitting diode ED and a second end of the capacitor Cst. The first transistor T1 may receive a data voltage DAT according to a switching operation of the second transistor T2, and may supply a driving current to the light emitting diode ED according to a voltage stored in the capacitor Cst.

A gate electrode G2 of the second transistor T2 is connected to a first scan line for transmitting a first scan signal SC, a source electrode S2 of the second transistor T2 is connected to a data line for transmitting a data voltage DAT or a reference voltage, and a drain electrode D2 of the second transistor T2 is connected to a first end of the capacitor Cst and a gate electrode G1 of the first transistor T1. The second transistor T2 may be turned on by the first scan signal SC to transmit the reference voltage or data voltage DAT to the gate electrode G1 of the first transistor T1 and the first end of the capacitor Cst.

A gate electrode G3 of the third transistor T3 is connected to a second scan line for transmitting a second scan signal SS, a source electrode S3 of the third transistor T3 is connected to the second end of the capacitor Cst, the drain electrode D1 of the first transistor T1, and the anode of the light emitting diode ED, and a drain electrode D3 of the third transistor T3 is connected to an initialization voltage line for transmitting an initialization voltage INIT. The third transistor T3 may be turned on by the second scan signal SS to transmit the initialization voltage INIT to the anode of the light emitting diode ED and the second end of the capacitor Cst and initialize the voltage at the anode of the light emitting diode ED.

The first end of the capacitor Cst is connected to the gate electrode G1 of the first transistor T1, and the second end of the capacitor Cst is connected to the source electrode S3 of the third transistor T3 and the anode of the light emitting diode ED. A cathode of the light emitting diode ED is connected to a common voltage line for transmitting the common voltage ELVSS.

The light emitting diode ED may emit light by a driving current formed by the first transistor T1.

An example of an operation of the circuit shown in FIG. 20, particularly an example of an operation for one frame, will now be described. A case in which the transistors T1, T2, and T3 are N-type channel transistors will be exemplified.

When one frame starts, for an initialization section, a high-level first scan signal SC and a high-level second scan signal SS are supplied to turn on the second transistor T2 and the third transistor T3. A reference voltage from a data line is supplied to the gate electrode G1 of the first transistor T1 and the first end of the capacitor Cst through the turned-on second transistor T2, and the initialization voltage INIT is supplied to the drain electrode D1 of the first transistor T1 and the anode of the light emitting diode ED through the turned-on third transistor T3. Accordingly, for the initialization section, the drain electrode D1 of the first transistor T1 and the anode of the light emitting diode ED are initialized with the initialization voltage INIT. A difference voltage between the reference voltage and the initialization voltage INIT is stored in the capacitor Cst.

For a sensing section, when the second scan signal SS becomes a low level while the high-level first scan signal SC is maintained, the second transistor T2 is maintained in the turned-on state, and the third transistor T3 is turned off. The gate electrode G1 of the first transistor T1 and the first end of the capacitor Cst maintains the reference voltage through the turned-on second transistor T2, and the drain electrode D1 of the first transistor T1 and the anode of the light emitting diode ED are disconnected from the initialization voltage INIT through the turned-off third transistor T3. Accordingly, the current flows to the drain electrode D1 of the first transistor T1 from the source electrode S1 of the first transistor T1, and the first transistor T1 is turned off when the voltage at the drain electrode D1 becomes "reference voltage-Vth". The Vth represents a threshold voltage of the first transistor T1. The voltage difference between the gate electrode G1 and the drain electrode D1 of the first transistor T1 is stored in the capacitor Cst, and sensing of the threshold voltage Vth of the first transistor T1 is finished. Characteristic deviation of the first transistor T1 that may be different for the respective pixels may be externally compensated by generating a compensated data signal by applying characteristic information sensed for the sensing section.

For a data input section, when a high-level first scan signal SC is supplied and a low-level second scan signal SS is supplied, the second transistor T2 is turned on and the third transistor T3 is turned off. The data voltage DAT from the data line is supplied to the gate electrode G1 of the first transistor T1 and the first end of the capacitor Cst through the turned-on second transistor T2. In this instance, the drain electrode D1 of the first transistor T1 and the anode of the light emitting diode ED may substantially maintain a potential in the sensing section by the turned-off first transistor T1.

For an emission section, the first transistor T1 turned on by the data voltage DAT transmitted to the gate electrode G1 may generate a driving current according to the data voltage DAT, and the light emitting diode ED may emit light by the driving current.

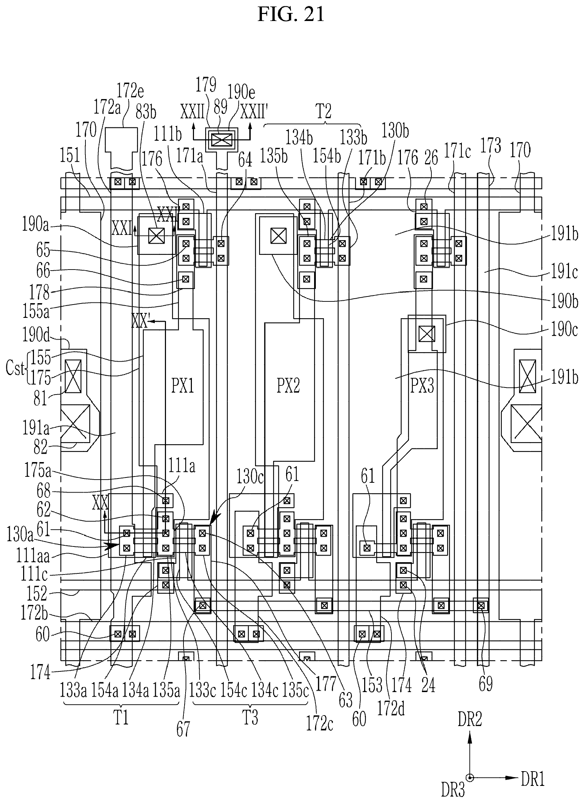

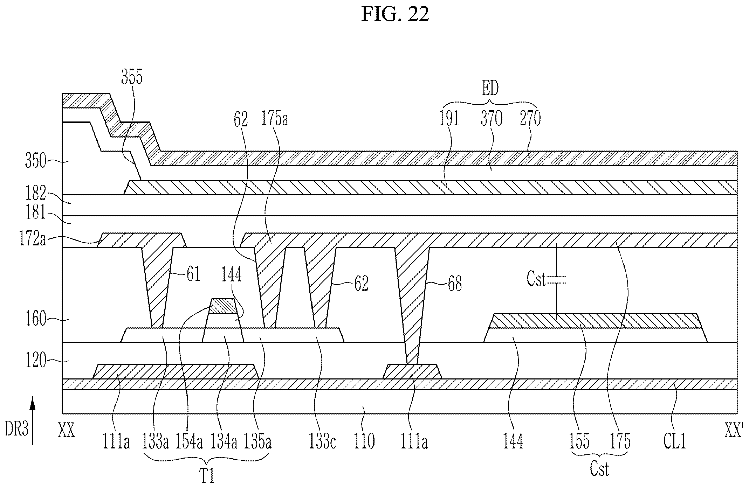

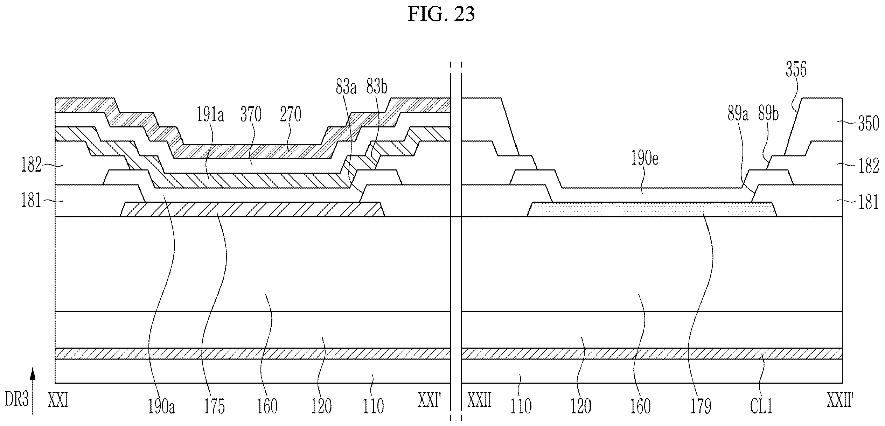

FIG. 21 shows a planar layout view of pixels PX1, PX2, and PX3 of a display device according to an embodiment. FIG. 22 shows a cross-sectional view of a display device shown in FIG. 21 along a line XX-XX'. FIG. 23 shows a cross-sectional view of a display device shown in FIG. 21 along the lines XXI-XXI' and XXII-XXII'.

Referring to FIG. 21 to FIG. 23, the display device according to the present embodiment may include a first substrate 110. The first substrate 110 may include an insulating material such as glass or plastic, and may have flexibility. The first substrate 110 may have a configuration that is identical to the substrate SUB according to embodiments described with reference to FIG. 1 to FIG. 19.

A first compensation layer CL1 may be positioned on the first substrate 110. The descriptions on the first compensation layer CL1 is identical to the above-provided description, so they will be omitted.

A lower layer including lower patterns 111a, 111b, and 111c as a first conductive layer may be positioned on the first compensation layer CL1. The lower layer has conductivity, and it may include various conductive metals or a semiconductor material with a conductive characteristic corresponding to them. The lower layer may have a configuration that is identical to the light blocking layer BML described with reference to FIG. 1 to FIG. 19.

A buffer layer 120 that is an insulating layer is positioned on the lower layer. That is, the lower layer may be positioned between the first substrate 110 and the buffer layer 120. The buffer layer 120 shown in FIG. 21 to FIG. 23 may have a configuration that is identical to the buffer layer BF described with reference to FIG. 1 to FIG. 19.

An active layer including active patterns 130a, 130b, and 130c is on the buffer layer 120. That is, the lower layer may be positioned between the first substrate 110 and the active layer. The active patterns 130a, 130b, and 130c on the respective pixels PX1, PX2, and PX3 may include channel areas 134a, 134b, and 134c for forming respective channels of the above-described transistors T1, T2, and T3 and conductive areas connected to the transistors T1, T2, and T3. The conductive areas of the active patterns 130a, 130b, and 130c include source areas 133a, 133b, and 133c and drain areas 135a, 135b, and 135c of the transistors T1, T2, and T3. The active pattern 130a may be connected to the active pattern 130c on the respective pixels PX1, PX2, and PX3.

The active layer described with reference to FIG. 21 to FIG. 23 may have a configuration that is identical to the semiconductor layer ACT described with reference to FIG. 1 to FIG. 19. The source areas 133a, 133b, and 133c described with reference to FIG. 21 to FIG. 23 may be identical to the source area SA described with reference to FIG. 1 to FIG. 19. The drain areas 135a, 135b, and 135c described with reference to FIG. 21 to FIG. 23 may be identical to the drain area DA described with reference to FIG. 1 to FIG. 19. The channel areas 134a, 134b, and 134c described with reference to FIG. 21 to FIG. 23 may be identical to the channel area CA described with reference to FIG. 1 to FIG. 19.

The active layer may include a semiconductor material such as amorphous silicon, polysilicon, or an oxide semiconductor.

An insulation pattern 144 that is a first insulating layer is positioned on the active layer. Particularly, the insulation pattern 144 may overlap the channel areas 134a, 134b, and 134c of the active patterns 130a, 130b, and 130c, and may be positioned in the channel areas 134a, 134b, and 134c. The insulation pattern 144 may not substantially overlap the conductive areas of the active patterns 130a, 130b, and 130c. The insulation pattern 144 may be identical to the gate insulating pattern GI described with reference to FIG. 1 to FIG. 19.

A second conductive layer may be positioned on the insulation pattern 144. The second conductive layer may include a first scan line 151 for transmitting the first scan signal SC, a second scan line 152 for transmitting the second scan signal SS, a horizontal initialization voltage line 153 for transmitting the initialization voltage INIT, a horizontal driving voltage line 172b for transmitting the driving voltage ELVDD, a driving gate electrode 155, a second gate electrode 154b, and a third gate electrode 154c. The gate electrode G1, the gate electrode G2, and the gate electrode G3 in the above-described circuit diagram are a first gate electrode 154a, the second gate electrode 154b, and the third gate electrode 154c.

The first gate electrode 154a, the second gate electrode 154b, and the third gate electrode 154c may be the gate electrode GE described with reference to FIG. 1 to FIG. 19.

The first and second scan lines 151 and 152, the horizontal initialization voltage line 153, and the horizontal driving voltage line 172b may respectively extend in a first direction DR1. The driving gate electrode 155 may be positioned between the first scan line 151 and the second scan line 152. The second gate electrode 154b may be connected to the first scan line 151 and may have a form protruding below the first scan line 151. The third gate electrode 154c may be connected to the second scan line 152 and may have a form protruding above the second scan line 152.

The driving gate electrode 155 positioned on the respective pixels PX1, PX2, and PX3 may include an extension 155a protruding upward and substantially extending in a second direction DR2, and a first gate electrode 154a protruding downward and substantially extending in the second direction DR2. The first gate electrode 154a positioned on the pixel PX3 may be bent at least twice on a portion connected to the driving gate electrode 155.

The first gate electrode 154a crosses the active pattern 130a and overlaps the channel area 134a of the active pattern 130a. The second gate electrode 154b crosses the active pattern 130b and overlaps the channel area 134b of the active pattern 130b. The third gate electrode 154c crosses the active pattern 130c and overlaps the channel area 134c of the active pattern 130c.

A second insulating layer 160 may be positioned on the second conductive layer. The buffer layer 120 and/or the second insulating layer 160 may include contact holes 24, 26, 60, 61, 62, 63, 64, 65, 66, 67, 68, and 69. The second insulating layer 160 may be the interlayer insulating layer ILD described with reference to FIG. 1 to FIG. 19.

A third conductive layer may be positioned on the second insulating layer 160. The third conductive layer may include data lines 171a, 171b, and 171c, a driving voltage line 172a, a common voltage line 170, an initialization voltage line 173, a capacitor electrode 175, connecting members 174, 176, 177, and 178, and driving voltage patterns 172c and 172d.

The third conductive layer may correspond to the source electrode SE and the drain electrode DE, and the data wire DATA including the same described with reference to FIG. 1 to FIG. 19. That is, the third conductive layer may be equal to or greater than 1000 nm (10,000 Å) thick, and it may include copper.

The data lines 171a, 171b, and 171c, the driving voltage line 172a, the common voltage line 170, the initialization voltage line 173, and the driving voltage patterns 172c and 172d may respectively substantially extend in the second direction DR2, and may cross the first scan line 151 and/or the second scan line 152.

A repeated group of pixels PX1, PX2, and PX3 shown in FIG. 21 may be arranged in the first direction DR1 and may be adjacent to each other. The common voltage line 170 may be positioned on respective sides of one group of pixels PX1, PX2, and PX3. That is, one common voltage line 170 may be positioned on one repeated group of pixels PX1, PX2, and PX3. When the one repeated group of pixels PX1, PX2, and PX3 includes three pixels PX1, PX2, and PX3, three data lines 171a, 171b, and 171c, at least one driving voltage line 172a, and at least one initialization voltage line 173 may be positioned between the two neighboring common voltage lines 170.

The respective data lines 171a, 171b, and 171c are electrically connected to the source area 133b of the active pattern 130b through at least one contact hole 64 (FIG. 19 shows two contact holes 64 in each of the pixels PX1, PX2, and PX3) of the second insulating layer 160.

FIG. 21 illustrates one data line 171a, and the respective data lines 171a, 171b, and 171c may include an end portion 179. The end portion 179 may be in a pad area positioned on an edge of the display device.

The driving voltage line 172a may be positioned on one pixel, for example, the pixel PX1, and the driving voltage patterns 172c and 172d may be positioned on the remaining pixels PX2 and PX3. The driving voltage line 172a may extend in the second direction DR2 and may extend to be adjacent to pixels. In a like manner of the data line 171a, the driving voltage line 172a may include an end portion 172e positioned in the pad area.

The driving voltage line 172a and the driving voltage patterns 172c and 172d are electrically connected to the source area 133a of the active pattern 130a through at least one contact hole 61 (FIG. 19 shows two contact holes 61 in the pixels PX1 and PX2 and one contact hole 61 in the pixel PX3) of the second insulating layer 160. The driving voltage line 172a and the driving voltage patterns 172c and 172d are electrically connected to the horizontal driving voltage line 172b through at least one contact hole 60 (FIG. 19 shows two contact holes 60 in each one of the pixels PX1, PX2, and PX3) of the second insulating layer 160. Therefore, the horizontal driving voltage line 172b and the driving voltage patterns 172c and 172d may transmit the driving voltage ELVDD together with the driving voltage line 172a, and the driving voltage ELVDD may be transmitted in a mesh form in the first direction DR1 and the second direction DR2 in the display device.

The initialization voltage line 173 is electrically connected to the horizontal initialization voltage line 153 through the contact hole 69 of the second insulating layer 160. Therefore, the horizontal initialization voltage line 153 may transmit the initialization voltage INIT together with the initialization voltage line 173, and it may transmit the initialization voltage INIT to the pixels PX1, PX2, and PX3 through the horizontal initialization voltage line 153 when one initialization voltage line 173 is provided for each group of the pixels PX1, PX2, and PX3.

The capacitor electrode 175 may be provided to the respective pixels PX1, PX2, and PX3. The capacitor electrode 175 may form a capacitor Cst by mostly overlapping the corresponding driving gate electrode 155 with the second insulating layer 160 between the capacitor electrode 175 and the corresponding driving gate electrode 155.

The capacitor electrode 175 may include a connector 175a protruding downward. The connector 175a is electrically connected to the drain area 135a of the active pattern 130a and the source area 133c of the active pattern 130c through at least one contact hole 62 (FIG. 19 shows three contact holes 62 in each one of the pixels PX1, PX2, and PX3) of the second insulating layer 160. The capacitor electrode 175 is electrically connected to the lower pattern 111a through the contact hole 68 of the second insulating layer 160 and the buffer layer 120.

The connecting member 174 may be electrically connected to the second scan line 152 and the lower pattern 111c through the two contact holes 24 of the buffer layer 120 and the second insulating layer 160, or of the second insulating layer 160. In this manner, the connecting member 174 electrically connects the second scan line 152 and the lower pattern 111c.

The connecting member 176 may be electrically connected to the first scan line 151 and the lower pattern 111b through the two contact holes 26 of the buffer layer 120 and the second insulating layer 160 or of the second insulating layer 160. In this manner, the connecting member 176 electrically connects the first scan line 151 and the lower pattern 111b.

The connecting member 177 may be electrically connected to the drain area 135c of the active pattern 130c through at least one contact hole 63 (FIG. 21 shows two contact holes 63 in each one of the pixels PX1, PX2, and PX3) of the second insulating layer 160 on the pixels PX1, PX2, and PX3, and may be electrically connected to the horizontal initialization voltage line 153 through the contact hole 67 of the second insulating layer 160. As a result, the drain area 135c of the active pattern 130c may be electrically connected to the horizontal initialization voltage line 153.

The horizontal initialization voltage line 153 extends in the first direction DR1 on the three adjacent pixels PX1, PX2, and PX3, but it may be positioned between two adjacent common voltage lines 170 and may not cross the two common voltage lines 170. The horizontal initialization voltage line 153 may cross three neighboring data lines 171a, 171b, and 171c, and may extend up to the initialization voltage line 173.

The connecting member 178 may be electrically connected to the drain area 135b of the active pattern 130b through at least one contact hole 65 (FIG. 21 shows two contact holes 65 in each one of the pixels PX1, PX2, and PX3) of the second insulating layer 160 on the respective pixels PX1, PX2, and PX3, and it is electrically connected to the extension 155a of the driving gate electrode 155 through the contact hole 66 of the second insulating layer 160. In this manner, the connecting member 178 electrically connects the drain area 135b of the active pattern 130b and the extension 155a of the driving gate electrode 155.

At least one of the first conductive layer, the second conductive layer, and the third conductive layer may include at least one of copper (Cu), aluminum (Al), magnesium (Mg), silver (Ag), gold (Au), platinum (Pt), palladium (Pd), nickel (Ni), neodymium (Nd), iridium (Ir), molybdenum (Mo), tungsten (W), titanium (Ti), chromium (Cr), tantalum (Ta), and an alloy thereof. The first conductive layer, the second conductive layer, and the third conductive layer may respectively include a single layer or multiple layers.

For example, the third conductive layer may have a multilayered structure including a lower layer including titanium and an upper layer including copper.

The first transistor T1 includes the channel area 134a, the source area 133a, the drain area 135a, and the first gate electrode 154a. The source area 133a of the first transistor T1 may be electrically connected to the driving voltage line 172a and the driving voltage patterns 172c and 172d to receive a driving voltage ELVDD.

The lower pattern 111a corresponding to the first transistor T1 may overlap the channel area 134a between the channel area 134a of the first transistor T1 and the first substrate 110 and may prevent external light from reaching the channel area 134a. Preventing external light from reaching the channel area 134a reduces a leakage current and characteristic deterioration. The lower pattern 111a is electrically connected to the drain area 135a of the first transistor T1 through the capacitor electrode 175.

The second transistor T2 includes the channel area 134b, the source area 133b, the drain area 135b, and the second gate electrode 154b. The source area 133b of the second transistor T2 is electrically connected to the data lines 171a, 171b, and 171c to receive a data voltage DAT or a reference voltage. The drain area 135b of the second transistor T2 may be electrically connected to the first gate electrode 154a through the driving gate electrode 155.

The lower pattern 111b corresponding to the second transistor T2 may overlap the channel area 134b between the channel area 134b of the second transistor T2 and the first substrate 110 and may prevent external light from reaching the channel area 134b. Preventing external light from reaching the channel area 134b reduces a leakage current and characteristic deterioration. The lower pattern 111b is electrically connected to the first scan line 151, so it may form a dual gate electrode of the second transistor T2 together with the second gate electrode 154b.

The third transistor T3 includes the channel area 134c, the source area 133c, the drain area 135c, and the third gate electrode 154c. The drain area 135c of the third transistor T3 may receive the initialization voltage INIT from the horizontal initialization voltage line 153.

The lower pattern 111c corresponding to the third transistor T3 may overlap the channel area 134c between the channel area 134c of the third transistor T3 and the first substrate 110 and may prevent external light from reaching the channel area 134c. Preventing external light from reaching the channel area 134c reduces a leakage current and characteristic deterioration. The lower pattern 111c is electrically connected to the second scan line 152, so it may form a dual gate electrode of the third transistor T3 together with the third gate electrode 154c.

A third insulating layer 181 may be positioned on the second insulating layer 160 and the third conductive layer. The third insulating layer 181 may include a contact hole 83a in the capacitor electrode 175, a contact hole 89a in the end portion 179 of the data lines 171a, 171b, and 171c, and a contact hole 81 in the common voltage line 170.

The third insulating layer 181 may be the intermediate layer PVX described with reference to FIG. 1 to FIG. 19.

A fourth conductive layer including ohmic contacts 190a, 190b, 190c, 190d, and 190e may be positioned on the third insulating layer 181.

The fourth conductive layer may correspond to the connection electrode CE described with reference to FIG. 1 to FIG. 19.

The respective ohmic contacts 190a, 190b, and 190c may be positioned on the pixels PX1, PX2, and PX3, the ohmic contacts 190a, 190b, and 190c may contact the capacitor electrode 175 through the contact hole 83a, and the ohmic contacts 190a, 190b, and 190c may be electrically connected the capacitor electrode 175. The ohmic contact 190d may contact the common voltage line 170 through the contact hole 81 and may be electrically connected to the common voltage line 170. The ohmic contact 190e may contact the end portion 179 of the data lines 171a, 171b, and 171c through the contact hole 89a and may be electrically connected to the data lines 171a, 171b, and 171c.

The ohmic contacts 190a, 190b, 190c, 190d, and 190e may increase adherence of the capacitor electrode 175 of the third conductive layer, the common voltage line 170, and the end portion 179 of the data lines 171a, 171b, and 171c to a conductive layer, and may prevent the third conductive layer from being oxidized. Particularly, when the upper layer of the third conductive layer includes copper, copper is prevented from being oxidized. For this purpose, the fourth conductive layer may include a conductive material for preventing the upper layer of the third conductive layer from being oxidized, for example, the conductive material for preventing the copper from being oxidized by capping the upper layer of the third conductive layer when the upper layer of the third conductive layer includes copper. For example, the fourth conductive layer may include a conductive material such as a metal oxide, e.g., an ITO or an IZO.

A fourth insulating layer 182 may be positioned on the third insulating layer 181 and the fourth conductive layer. The fourth insulating layer 182 may include a contact hole 83b positioned in the ohmic contacts 190a, 190b, and 190c and overlapping the contact hole 83a, and a contact hole 89b positioned in the ohmic contact 190e and overlapping the contact hole 89a. A fifth insulating layer 350 on the fourth insulating layer 182 may include an opening 356 corresponding to the contact hole 89b.

The fourth insulating layer 182 may be the organic layer VIA described with reference to FIG. 1 to FIG. 19.

The ohmic contact 190e may be exposed to an outside by the contact hole 89b, and may be electrically connected to an additional driving circuit chip, a circuit film, or a circuit board.

At least one of the buffer layer 120, the first insulating layer, the second insulating layer 160, the third insulating layer 181, and the fourth insulating layer 182 may include an inorganic insulating material and/or an organic insulating material such as a silicon nitride (SiNx), a silicon oxide (SiOx), or a silicon oxynitride (SiON). Particularly, the fourth insulating layer 182 may include an inorganic insulating material and/or an organic insulating material such as a polyimide, an acryl-based polymer, or a siloxane-based polymer, and it may substantially have a planar top side.

A pixel electrode layer 191 including pixel electrodes 191a, 191b, and 191c as a fifth conductive layer may be positioned on the fourth insulating layer 182. The respective pixel electrodes may include a first pixel electrode 191a, a second pixel electrode 191b, and a third pixel electrode 191c. The respective pixel electrodes 191a, 191b, and 191c may be positioned corresponding to the pixels PX1, PX2, and PX3 as shown in FIG. 21. The respective pixels include a first pixel PX1, a second pixel PX2, and a third pixel PX3.

The respective pixel electrodes 191a, 191b, and 191c may contact the ohmic contacts 190a, 190b, and 190c through the contact hole 83b, and may be electrically connected to the capacitor electrode 175 through the ohmic contacts 190a, 190b, and 190c. Therefore, the respective pixel electrodes 191a, 191b, and 191c may be electrically connected to the drain area 135a of the first transistor T1 and may receive a voltage from the first transistor T1.

The pixel electrode layer may include a semi-transparent conductive material or a reflective conductive material.

The pixel electrode layer may be the first electrode PXE described with reference to FIG. 1 to FIG. 19.

The fifth insulating layer 350 may be positioned on the fourth insulating layer 182. The fifth insulating layer 350 includes an opening 355 in the pixel electrodes 191a, 191b, and 191c. The fifth insulating layer 350 may include an organic insulating material such as a poly acryl-based resin or a polyimide-based resin.

The fifth insulating layer 355 may be the partition wall PDL described with reference to FIG. 1 to FIG. 19.

An emission layer 370 is positioned on the fifth insulating layer 350 and the pixel electrode layer. The emission layer 370 may include a portion positioned in the opening 355 of the fifth insulating layer 350. The emission layer 370 may include an organic emission material or an inorganic emission material. Differing from what is illustrated, at least part of the fifth insulating layer 350 may not be covered by the emission layer 370.

The fifth insulating layer 350 and the emission layer 370 may include a contact hole 82 in the ohmic contact 190d.

The emission layer 370 may be the emission layer EML described with reference to FIG. 1 to FIG. 19.

A common electrode 270 is positioned on the emission layer 370. The common electrode 270 may be continuously formed throughout pixels PX1, PX2, and PX3. The common electrode 270 may contact the ohmic contact 190d through the contact hole 82 to be electrically connected to the common voltage line 170 and receive the common voltage ELVSS.

The common electrode 270 may include a conductive transparent material.

The common electrode 270 may be the second electrode CME described with reference to FIG. 1 to FIG. 19.

The pixel electrodes 191a, 191b, and 191c, the emission layer 370, and the common electrode 270 of the pixels PX1, PX2, and PX3 configure a light emitting diode ED, and one of the pixel electrodes 191a, 191b, and 191c, and the common electrode 270, becomes a cathode and the other becomes an anode. The case in which the pixel electrodes 191a, 191b, and 191c become an anode has been described.

Referring to FIG. 21, the lower pattern 111a may further include an expansion 111aa overlapping the driving voltage line 172a and the driving voltage patterns 172c and 172d in a plan view. Accordingly, the size of the lower pattern 111a may be greater than the size of the lower pattern 111b or the lower pattern 111c in a plan view. According to the present embodiment, the lower pattern 111a is electrically connected to the pixel electrodes 191a, 191b, and 191c that are anodes through the capacitor electrode 175, and the expansion 111aa of the lower pattern 111a overlaps the driving voltage line 172a and the driving voltage patterns 172c and 172d for transmitting a predetermined voltage with the buffer layer 120 and the second insulating layer 160 between the expansion 111aa and the driving voltage line 172a and the driving voltage patterns 172c and 172d. In this manner, the capacitor Cst for reinforcing the function for maintaining the voltage at the anode may be formed.

The expansion 111aa may overlap the source area 133a of the active pattern 130a connected to the driving voltage line 172a.

The lower pattern 111a is electrically connected to the pixel electrodes 191a, 191b, and 191c through the capacitor electrode 175 and overlaps the channel area 134a of the first transistor T1. Accordingly, a current change rate is reduced in a saturation region in a voltage-current characteristic graph of the first transistor T1 and an output current of the first transistor T1 may increase to a predetermined range. Therefore, when the voltage Vds between the source and the drain of the first transistor T1 changes, an output current of the first transistor T1 is constant, so an output saturation characteristic may be improved. Luminance deviation among pixels caused by the output current of the first transistor T1 may be reduced and image quality may be increased.

The configuration including the first compensation layer CL1, which is an embodiment of FIG. 1 has been exemplified with reference to FIG. 21 to FIG. 23. However, various embodiments may be applied to the configuration described with reference to FIG. 21 to FIG. 23. That is, it is possible to apply the various embodiments disclosed with reference to FIG. 1 to FIG. 19 to the configuration described with reference to FIG. 21 to FIG. 23.

While the inventive concept has been described in connection with what is presently considered to be practical embodiments, it is to be understood that the inventive concept is not limited to the disclosed embodiments, but, on the contrary, is intended to cover various modifications and equivalents included within the scope of the appended claims.

## Claims

1. A display device comprising:
a substrate (SUB);
a buffer layer (BF) on the substrate (SUB);
a semiconductor layer (ACT) on the buffer layer (BF);
a data wire (DATA) including a source electrode (SE) and a drain electrode (DE) connected to the semiconductor layer (ACT); and
a light-emitting device (ED) connected to the drain electrode (DE),
**characterized by**
at least a compensation layer (CL1-CL4) which includes SiNx, and wherein
a ratio of a N-H bond and a Si-H bond of the at least one compensation layer (CL1-CL4) is 10 to 60 and/or a stress of the at least one compensation layer (CL1-CL4) is -400 MPa to -1600 MP, and wherein the compensation layer (CL1-CL4) or respectively a compensation layer (CL1-CL4) is positioned
between the substrate (SUB) and the buffer layer (BF) and/or
between the buffer layer (BF) and the semiconductor layer (ACT) and/or
directly or indirectly on an interlayer insulating layer (ILD), which is positioned on the semiconductor layer (ACT), and/or
between an organic layer (VIA), which is positioned between the data wire (DATA) and the light-emitting device (ED), and the data wire (DATA).

2. The display device of claim 1, wherein
a thickness of a compensation layer (CL1), which is positioned between the substrate (SUB) and the buffer layer (BF), and/or of a compensation layer (CL4), which is positioned between the organic layer (VIA) and the data wire (DATA), is 100 nm to 400 nm.

3. The display device of claim 1 or 2, wherein
a thickness of a compensation layer (CL2), which is positioned between the buffer layer (BF) and the semiconductor layer (ACT), and/or of a compensation layer (CL3), which is positioned on the interlayer insulating layer (ILD), is 100 nm to 300 nm.

4. The display device of at least one of claims 1 to 3, wherein
a hydrogen content of one, several or all of the compensation layers (CL1-CL4) is equal to or less than 15 %.

5. The display device of at least one of claims 1 to 4, wherein
the semiconductor layer (ACT) includes an oxide semiconductor, and
the data wire (DATA) includes copper.

6. The display device of at least one of claims 1 to 5, wherein
a thickness of the data wire (DATA) is equal to or greater than 1000 nm.

7. The display device of at least one of claims 1 to 6, comprising at least two of the compensation layers (CL1-CL4).

8. The display device of at least one of claims 1 to 6, comprising at least three of the compensation layers (CL1-CL4).

9. The display device of at least one of claims 1 to 6, comprising all of the four compensation layers (CL1-CL4).

10. The display device of at least one of claims 1 to 6, comprising
a first compensation layer (CL1) which is the compensation layer (CL1) between the substrate (SUB) and the buffer layer (BF).

11. The display device of at least one of claims 1 to 6, comprising
a first compensation layer (CL1) which is the compensation layer (CL1) between the substrate (SUB) and the buffer layer (BF) and a second compensation layer (CL2) which is the compensation layer (CL2) between the buffer layer (BF) and the semiconductor layer (ACT).

12. The display device of at least one of claims 1 to 6, comprising
the compensation layer (CL2) between the buffer layer (BF) and the semiconductor layer (ACT).

13. The display device of at least one of claims 10 to 12, further comprising
the compensation layer (CL3) on the interlayer insulating layer (ILD).

14. The display device of at least one of claims 1 to 6, comprising
the compensation layer (CL3) on the interlayer insulating layer (ILD).

15. The display device of at least one of claims 10 to 14, further comprising
the compensation layer (CL4) between the organic layer (VIA) and the data wire (DATA), wherein the compensation layer (CL4) especially is positioned on an intermediate layer (PVX), which is positioned on the data wire (DATA).
